# EUROPEAN PATENT APPLICATION

(11) **EP 4 672 929 A1**
(43) Date of publication of application: **31.12.2025**
(21) Application number: 25179009.3
(22) Date of filing: 27.05.2025
(51) Int. Cl.: H10K 30/86, H10K 71/40

(54) **MANUFACTURING METHOD FOR SOLAR CELL MODULE AND SOLAR CELL MODULE**

(30) Priority: 28.06.2024 JP 2024104951
(71) Applicant: TOYOTA JIDOSHA KABUSHIKI KAISHA, Toyota-shi, Aichi-ken 471-8571 (JP)
(72) Inventor: AOKI, Yoichi, Toyota-shi, 471-8571 (JP); MABUCHI, Takashi, Toyota-shi, 471-8571 (JP); KOTAKE, Kazuki, Toyota-shi, 471-8571 (JP)
(74) Representative: J A Kemp LLP

(57) **Abstract**

A manufacturing method for a solar cell module having stacked hole transport (11), photoelectric conversion (12), and electron transport layers (13) includes: preparing a substrate with the hole transport layer formed therein; performing hydrophilic treatment on the hole transport layer surface on a first substrate; causing the hole transport layer surface to absorb moisture; applying a precursor for the photoelectric conversion layer to the hole transport layer surface with moisture absorbed therein; heating the precursor to form the photoelectric conversion layer from the precursor and vaporizing moisture absorbed in the hole transport layer surface, thereby forming vacancies (21) at an interface of the photoelectric conversion layer contacting the hole transport layer; and forming the electron transport layer on the photoelectric conversion layer surface.

## Description

### BACKGROUND

### Technical Field

The present disclosure relates to a manufacturing method for a solar cell module and a solar cell module.

### Background Art

As a technique of this kind, for example, JP 2023-538996 A discloses a manufacturing method for a perovskite solar cell. The manufacturing method includes the steps of applying a solution as a precursor for a perovskite layer to a surface of a hole transport layer and drying the applied solution to form the perovskite layer from the solution. The hole transport layer includes a nickel oxide, and the nickel oxide is further oxidized before application of the precursor for the perovskite layer so as to form nickel vacancies in the hole transport layer. As a result, the hole extraction efficiency in the hole transport layer can be improved. Note that the nickel vacancies are electronic vacancies, but not physical vacancies.

### SUMMARY

However, a perovskite solar cell manufactured using the manufacturing method disclosed in JP 2023-538996 A is insufficient in improving an open-circuit voltage and still needs to be improved.

The present disclosure has been made in view of such an issue, and provides a manufacturing method for a solar cell module capable of improving an open-circuit voltage of the solar cell module, and a solar cell module.

Now, general recognition has been that a stable power generation performance can be obtained by forming a photoelectric conversion layer without physical vacancies (voids) in manufacturing a solar cell module of this kind. However, the inventors' devoted study in view of such an issue has led to a new finding that the open-circuit voltage of the solar cell module improves with physical vacancies provided at specific positions of the photoelectric conversion layer. The present disclosure is based on such a new finding by the inventors. Note that in the present application, vacancies used hereinafter refer to physical vacancies, unless otherwise particularly mentioned.

A manufacturing method for a solar cell module according to the present disclosure based on such a finding is a manufacturing method for a solar cell module in which a hole transport layer, a photoelectric conversion layer, and an electron transport layer are stacked. The manufacturing method includes: preparing a substrate where the hole transport layer is formed; performing a hydrophilic treatment on a surface of the hole transport layer formed on the substrate prepared; causing the surface of the hole transport layer on which the hydrophilic treatment is performed to absorb moisture; applying a precursor for the photoelectric conversion layer to the surface of the hole transport layer in which the moisture is absorbed; heating the precursor applied so as to form the photoelectric conversion layer from the precursor and vaporizing the moisture absorbed in the surface of the hole transport layer, thereby forming a plurality of vacancies at an interface of the photoelectric conversion layer contacting the hole transport layer; and forming the electron transport layer on a surface of the photoelectric conversion layer.

The manufacturing method for a solar cell module according to the present disclosure causes the surface of the hole transport layer on which the hydrophilic treatment is performed to absorb moisture and then, applies the precursor for the photoelectric conversion layer to the surface of the hole transport layer with the moisture absorbed therein and heats the precursor. The moisture absorbed in the surface of the hole transport layer is evaporated due to the heating, so that a plurality of vacancies (voids) is formed at the interface of the photoelectric conversion layer contacting the hole transport layer. According to the solar cell module having such vacancies, when the photoelectric conversion layer is irradiated with light such as sunlight, the light energy is converted to generate free electrons and holes. The holes move from the photoelectric conversion layer to the hole transport layer. At this time, the holes cannot pass through the vacancies formed at the interface of the photoelectric conversion layer contacting the hole transport layer and thus move by bypassing the vacancies. Therefore, since the holes tend to densely gather between the plurality of vacancies, generation of nonradiative recombination at the interface can be suppressed. As a result, the open-circuit voltage of the solar cell module manufactured by the manufacturing method can be improved.

Here, the specific hydrophilic treatment method may be, for example, a non-contact hydrophilic treatment such as a plasma treatment, a UV (Ultra Violet) ozone treatment, or a corona treatment, or a chemical treatment involving contact with a hydrophilic agent, without being particularly limited, as long as the vacancies can be formed through hydrophilic treatment and moisture absorption. However, in some aspects, in the process of the hydrophilic treatment of the surface of the hole transport layer, a plasma treatment or a UV ozone treatment may be performed.

According to this aspect, moisture suspending in the atmosphere is more easily absorbed in the surface of the hole transport layer, and uniform application of the precursor to the surface of the hole transport layer with moisture absorbed therein is facilitated. In particular, by performing the hydrophilic treatment using the plasma treatment, the moisture suspending in the atmosphere can be absorbed for a short period of time.

Here, examples of the plasma treatment may include an atmospheric plasma treatment and a vacuum plasma treatment. In some aspects, the plasma treatment may be a vacuum plasma treatment, and in the vacuum plasma treatment, plasma is irradiated to the surface of the hole transport layer, with an integrated intensity indicating an irradiation intensity per unit irradiation area of the plasma being equal to or greater than 509 mJ/cm².

According to this aspect, in the manufactured solar cell module, the plurality of vacancies can be formed such that on a cut surface obtained by cutting, along a thickness direction, the hole transport layer and the photoelectric conversion layer, a ratio of a total length of a surface of the hole transport layer, the surface adjacent to the plurality of vacancies, relative to an entire length of the hole transport layer facing the photoelectric conversion layer is equal to or greater than 20%. As a result, the open-circuit voltage of the solar cell module can be improved.

Further, as long as the plurality of vacancies can be formed, an upper limit value of the integrated intensity in the vacuum plasma treatment is not particularly limited. However, in some aspects, in the vacuum plasma treatment, the plasma is irradiated to the surface of the hole transport layer, with the integrated intensity being equal to or smaller than 1528 mJ/cm².

According to this aspect, in the manufactured solar cell module, the plurality of vacancies can be formed such that on the cut surface obtained by cutting, along the thickness direction, the hole transport layer and the photoelectric conversion layer, the ratio of the total length of the surface of the hole transport layer, the surface adjacent to the plurality of vacancies, relative to the entire length of the hole transport layer facing the photoelectric conversion layer is equal to or smaller than 30%. As a result, even when a plurality of solar cell modules is manufactured, an increase in the series resistance of the solar cell modules can be stably suppressed.

Further, in view of the aforementioned issue, a solar cell module according to the present disclosure is a solar cell module in which a hole transport layer, a photoelectric conversion layer, and an electron transport layer are stacked, in which a plurality of vacancies is formed at an interface of the photoelectric conversion layer contacting the hole transport layer.

According to the present disclosure, when the holes converted from light in the photoelectric conversion layer move from the photoelectric conversion layer to the hole transport layer, the holes move by bypassing the vacancies formed at the interface of the photoelectric conversion layer contacting the hole transport layer. Therefore, the holes densely gather to easily move between the plurality of vacancies. Thus, generation of nonradiative recombination at the interface between the photoelectric conversion layer and the hole transport layer can be suppressed. As a result, the open-circuit voltage of the solar cell module can be improved.

Considering the improvement in the open-circuit voltage of the solar cell module due to such vacancies, the ratio of the vacancies to be formed is not limited, as long as the vacancies are formed at the interface of the photoelectric conversion layer contacting the hole transport layer. However, in some aspects, on a cut surface obtained by cutting, along a thickness direction, the hole transport layer and the photoelectric conversion layer, the ratio of the total length of the surface of the hole transport layer, the surface adjacent to the plurality of vacancies, relative to the entire length of the hole transport layer facing the photoelectric conversion layer is equal to or greater than 20%.

According to this aspect, with the vacancy forming ratio equal to or greater than 20%, the holes easily intensively flow between the plurality of vacancies so that the open-circuit voltage of the solar cell module can be further improved.

In another aspect, the ratio of the total length of the surface of the hole transport layer, the surface adjacent to the plurality of vacancies, relative to the entire length of the hole transport layer facing the photoelectric conversion layer is equal to or smaller than 30%.

According to this aspect, even when a plurality of solar cell modules is manufactured, an increase in the series resistance of the solar cell modules can be stably suppressed.

According to the present disclosure, an open-circuit voltage of a solar cell module can be improved.

### BRIEF DESCRIPTION OF THE DRAWINGS

FIG. 1 is a schematic view showing the structure of a cross section of a solar cell module according to the present embodiment;
FIG. 2 is a schematic view for explaining the advantageous effects produced by the solar cell module according to the present embodiment;
FIG. 3 is a flowchart showing a manufacturing method for the solar cell module according to the present embodiment;
FIG. 4A is an explanatory view corresponding to step S1 shown in the flowchart of FIG. 3;
FIG. 4B is an explanatory view corresponding to step S2 shown in the flowchart of FIG. 3;
FIG. 4C is an explanatory view corresponding to step S3 shown in the flowchart of FIG. 3;
FIG. 4D is an explanatory view corresponding to step S4 shown in the flowchart of FIG. 3;
FIG. 4E is an explanatory view corresponding to step S5 shown in the flowchart of FIG. 3;
FIG. 5A is a schematic view for further detailing the step shown in FIG. 4E;
FIG. 5B is a schematic view for further detailing the step shown in FIG. 4E;
FIG. 6A and FIG. 6B are photographed textures of cross sections of hole transport layers and photoelectric conversion layers according to Example 1-1 and Comparative Example 1, respectively;
FIG. 7 is a table showing evaluation results of a vacancy forming ratio and a power generation performance according to Example 1-1 to Example 1-3 and Comparative Example 1; and
FIG. 8A is a graph showing open-circuit voltages of solar cell modules according to Example 2-1 to Example 2-6 and Comparative Example 2; and
FIG. 8B is a graph showing series resistances of solar cell modules according to Example 2-1 to Example 2-6 and Comparative Example 2.

### DETAILED DESCRIPTION

### [Embodiment]

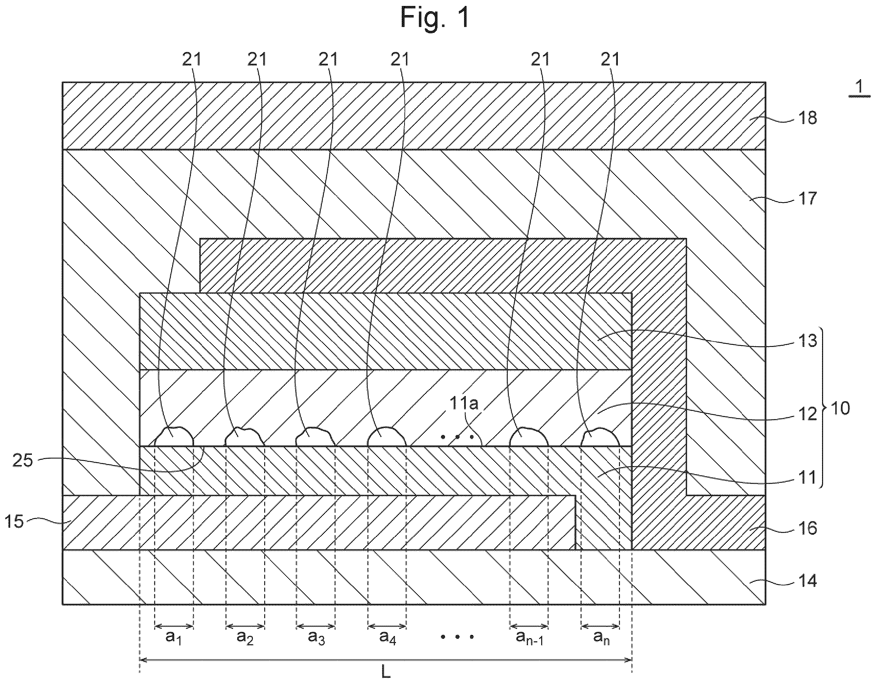

Hereinafter, an embodiment of the present disclosure will be described in detail with reference to FIG. 1 to FIG. 5B. Note that the embodiment shown below is one aspect of the present disclosure and does not limit the technical scope of the present disclosure.

### <Structure>

FIG. 1 is a schematic view showing the structure of a cross section of a solar cell module 1 according to the present embodiment. The solar cell module 1 includes a layered power generation portion 10. In the power generation portion 10, a hole transport layer 11, a photoelectric conversion layer 12, and an electron transport layer 13 are sequentially stacked. The solar cell module 1 includes a first and a second electrodes 15, 16. On one surface (specifically, a surface of the hole transport layer 11) of the power generation portion 10, the first electrode 15 is formed and on the other surface (specifically, a surface of the electron transport layer 13), the second electrode 16 is formed. In the present embodiment, the solar cell module 1 further includes first and second substrates 14, 18 that sandwich the power generation portion 10 where the first and the second electrodes 15, 16 are formed. The first substrate 14 is disposed contacting the first electrode 15 and the second substrate 18 is disposed on the second electrode 16 side. The solar cell module 1 further includes an adhesive sealing material 17 that entirely seals the power generation portion 10 and the like so as to fill a gap between the first substrate 14 and the second substrate 18.

The first substrate 14 is composed of a translucent material, for example, glass or resin. Examples of a translucent resin may include a polyimide resin, a polyamide resin, and a polyethylene terephthalate resin. Here, the first substrate 14 corresponds to the substrate of the present disclosure and may be in any form of a board, a sheet, and a film. When the solar cell module 1 is flexible, the first substrate 14 may be a resin film.

The first electrode 15 is a positive electrode that collects holes H and is composed of a transparent conductive oxide (TCO) having conductivity and a light transmitting property. Examples of the transparent conductive oxide may include an indium oxide, a tin oxide, a zinc oxide, a titanium oxide, and a composite oxide thereof. Considering high conductivity and transparency, the transparent conductive oxide may be an indium-based composite oxide having an indium oxide as the main component among those listed above, and an element such as Sn, W, Zn, or Ti may be further additionally doped. In the present embodiment, the first electrode 15 is composed of a translucent oxide metal material, such as an indium tin oxide (ITO) and an indium zinc oxide (IZO).

The second substrate 18 may be composed of the same material as that of the first substrate 14, in any form of a board, a sheet, and a film. In the present embodiment, since the solar cell module 1 receives light such as sunlight through the first substrate 14, the second substrate 18 does not need to have a light transmitting property. Likewise, the second electrode 16, which is a negative electrode paired with the first electrode 15 in the present embodiment, may be composed of the same material as that of the first electrode 15, but does not need to have a light transmitting property for the same reason. In this case, the second electrode 16 may be composed of metal such as copper, silver, gold, and platinum, and may be, for example, in a multi-layer structure including a layer of the aforementioned transparent conductive oxide and the like. However, when a tandem solar cell unit is adopted in which a silicon-based solar cell module is further arranged at a position facing the power generation portion 10 of the solar cell module 1, the second substrate 18 and the second electrode 16 are composed of the same material having a light transmitting property as those of the first substrate 14 and the first electrode 15.

Note that the first and the second electrodes 15, 16 may be formed by, for example, vapor deposition or may be formed such that a solution or a dispersion corresponding to a precursor for the electrode is applied and then dried. The forming method may be a known method, without being particularly limited.

The hole transport layer 11 is formed of, for example, a p-type semiconductor, and receives charges (holes) generated in the photoelectric conversion layer 12 and transmits the received charges to the first electrode 15. The hole transport layer 11 has a light transmitting property and is translucent, including, as a main material, PTAA (Poly(bis(4-phenyl)(2,4,6-trimethylphenyl)amine)), Fluoro-PTAA, Poly-TPD ([N,N'-bis(4-butylphenyl)-N,N'-bis(phenyl)-benzidine]), F8BT ([Poly[(9,9-dioctylfluorenyl-2,7-diyl)-alt-(benzo[2,1,3]thiadiazol-4,7-diyl)]]), or the like.

The photoelectric conversion layer 12 is capable of converting an irradiated light energy into an electric energy, and absorbs light received in the solar cell module 1 and converts the absorbed light into free electrons and holes. In the present embodiment, the photoelectric conversion layer 12 is capable of converting the irradiated light energy into the electric energy and includes a compound having a perovskite crystal structure as a main material. In the present embodiment, a perovskite layer is shown below as an example of the photoelectric conversion layer 12, but the photoelectric conversion layer 12 is not particularly limited as long as it can convert the absorbed light into electrons and holes. In the present embodiment, the photoelectric conversion layer 12 is a perovskite layer including, as a main material, a compound having the perovskite crystal structure. Examples of such a compound may include methyl ammonium lead-halide and methyl ammonium lead iodide. Alternatively, halogen atoms may partially include a bromine atom or a chlorine atom.

The electron transport layer 13 is formed of, for example, an n-type semiconductor, and receives charges (free electrons) generated in the photoelectric conversion layer 12 and transmits the received charges to the second electrode 16. The electron transport layer 13 includes, as a main material, PCBM ([6,6]-Phenyl-C61-Butylic Acid Methyl Ester), BCP (Bathocuproine), or the like. The electron transport layer 13 may be a stacked layer of a PCBM layer and a BCP layer.

At an interface 25 of the photoelectric conversion layer 12 contacting the hole transport layer 11, a plurality of (n) vacancies (voids) 21 as cavity portions is formed. Note that the vacancies 21 are physical vacancies, that is, voids. In the present embodiment, the size and the ratio of the plurality of vacancies 21 to be formed are defined on a cut surface obtained by cutting the hole transport layer 11 and the photoelectric conversion layer 12 along the thickness direction. Specifically, as shown in FIG. 1, when n vacancies 21 are formed, each of a₁ to aₙ, which are lengths of a surface 11a adjacent to the vacancies 21, is several hundred nm to several µm. The thickness of the photoelectric conversion layer 12 is equal to or greater than 100 nm and equal to or smaller than 1000 nm, and the height of each vacancy 21 may be, for example, equal to or greater than 20% and equal to or smaller than 50% of the thickness of the photoelectric conversion layer 12 in order to facilitate exhibiting the advantageous effects described later. The plurality of vacancies 21 is densely formed in a range of several ten µm in an island shape (in a dendrite) due to the method of forming the vacancies 21 described later. As will be detailed later in Examples, the vacancy forming ratio may be equal to or greater than 20%, and may be equal to or smaller than 30% in some cases. Note that the vacancy forming ratio referred to herein is the ratio of a sum of a₁ to aₙ relative to an entire length L of the hole transport layer 11 (i.e., a value obtained by dividing the sum of a₁ to aₙ by L and the obtained result is multiplied by 100). In the embodiment of the present application, the vacancy forming ratio is defined as described above, but the vacancy forming ratio may be a value specified in any cross section of the hole transport layer 11 and the photoelectric conversion layer 12 along the thickness direction of the layers. Note that it is difficult to measure a total surface area of the photoelectric conversion layer 12 adjacent to the vacancies 21 at the interface between the hole transport layer 11 and the photoelectric conversion layer 12. Further, since the vacancy forming ratio defined above and the power generation performance of the solar cell module 1 in Examples described later corelate with each other, the inventors define the vacancy forming ratio as described above.

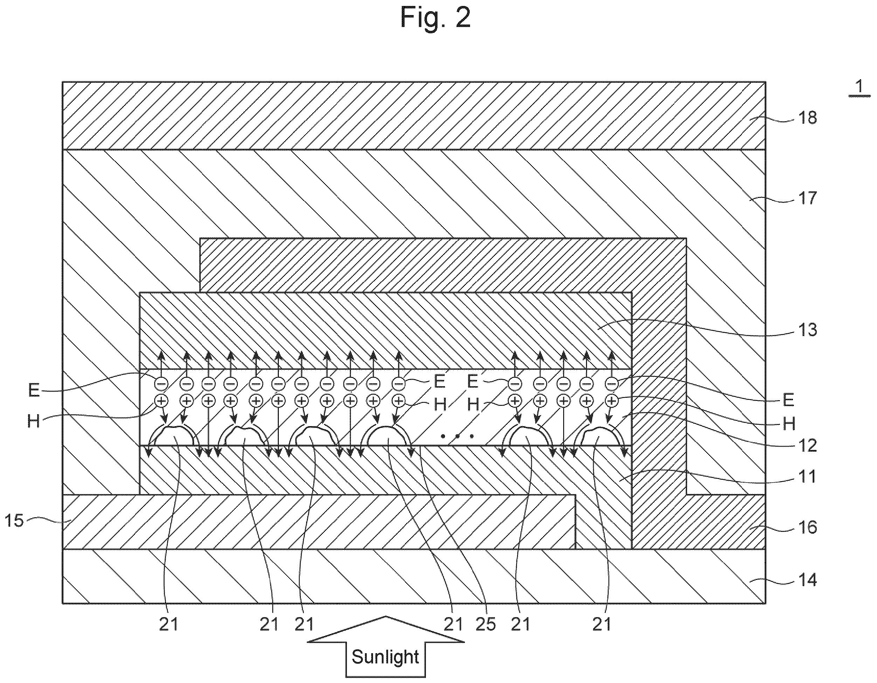

Using FIG. 2, the general principle of power generation of the solar cell module 1 according to the present embodiment and the specific advantageous effects produced by the solar cell module 1 will be described. First, upon irradiation of an irradiation light such as sunlight through the first substrate 14 side of the solar cell module 1, since the hole transport layer 11, the first substrate 14, and the first electrode 15 are translucent as described above, the irradiation light passes through these portions to reach the photoelectric conversion layer 12. Of the irradiation light that has reached the photoelectric conversion layer 12, the irradiation light having a specific wavelength is absorbed in the photoelectric conversion layer 12. The absorbed irradiation light is converted into a plurality of holes H and free electrons E. The converted holes H and free electrons E move to the hole transport layer 11 and the electron transport layer 13, respectively, and are subsequently collected in the first electrode 15 and the second electrode 16. In this manner, the solar cell module 1 generates power.

Here, when the holes H move to the hole transport layer 11, since the vacancies 21 are cavity portions, the holes H cannot pass through the vacancies 21. Therefore, the holes H move to the hole transport layer 11 by bypassing the vacancies 21. Because of this, the holes H tend to densely gather between the plurality of vacancies 21, thereby enabling to suppress generation of nonradiative recombination at the interface 25 of the photoelectric conversion layer 12. As a result, the open-circuit voltage of the solar cell module 1 can be improved. Note that the adequate range of the vacancy forming ratio at the interface 25 will be described in Examples later.

### <Manufacturing method>

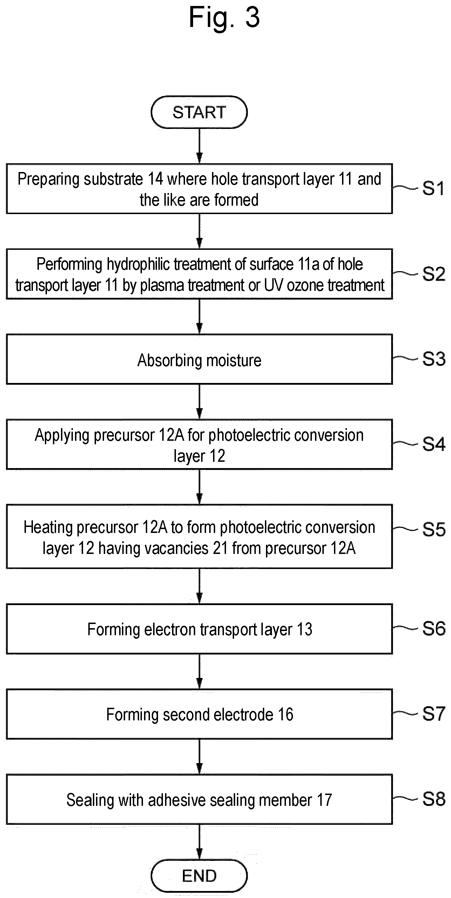

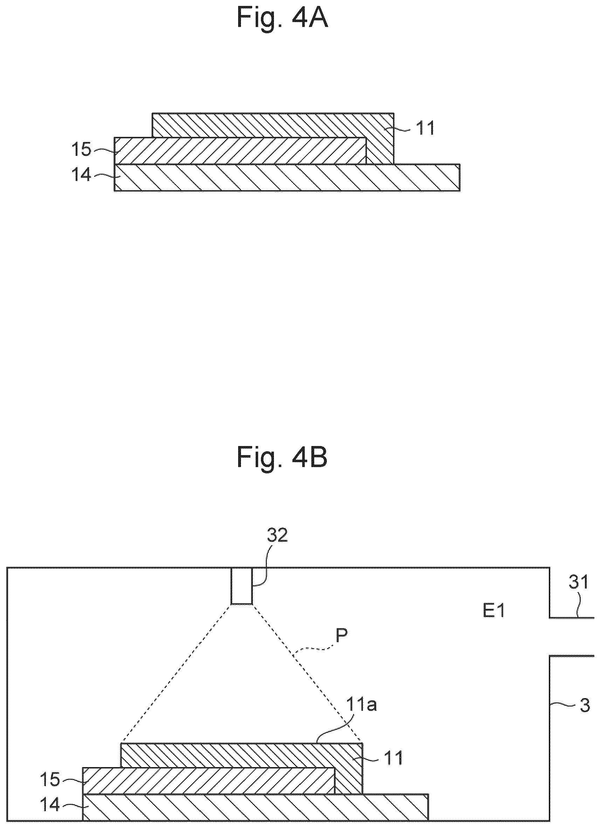

Using a flowchart shown in FIG. 3 and with reference to FIG. 4A to FIG. 5E for main steps, a manufacturing method for the solar cell module 1 according to the present embodiment will be described. First, in step S1, the first substrate 14 where the hole transport layer 11 and the first electrode 15 are formed is prepared. Specifically, as shown in FIG. 4A, the first electrode 15 is formed on a surface of the first substrate 14 using the aforementioned method and the hole transport layer 11 is formed so as to cover a surface of the first electrode 15. In forming the hole transport layer 11, the first substrate 14 where the first electrode 15 is formed is coated with an organic solution such as the aforementioned PTAA and a precursor (solution) that becomes the hole transport layer 11 is dried.

Next, in step S2, the surface 11a of the hole transport layer 11 formed on the prepared first substrate 14 is subjected to a hydrophilic treatment. An example of the hydrophilic treatment by a vacuum plasma treatment will be described below. Specifically, as shown in FIG. 4B, the first substrate 14 where the aforementioned hole transport layer 11 and the like are formed is housed in a chamber 3, and a space E1 inside the chamber 3 is depressurized by vacuuming using a vacuum pump (not shown) via an exhaust pipe 31. Next, plasma P is supplied to the space E1 via a supply pipe 32 and is irradiated to the surface 11a of the hole transport layer 11. By performing the vacuum plasma treatment, a functional group contributing to the hydrophilic property can be increased on the surface 11a, thereby being able to improve the hydrophilic property of the surface 11a.

Note that this hydrophilic treatment is a treatment that improves the surface modification to allow the surface 11a of the hole transport layer 11 to be more hydrophilic as compared to a hydrophilic treatment only for the purpose of increasing wettability of the solution that becomes a precursor 12A for the photoelectric conversion layer 12. That is, in the present embodiment, the moisture absorption (water absorption) of the surface 11a of the hole transport layer 11 is increased by irradiating the surface 11a of the hole transport layer 11 with the plasma P having a higher energy as compared to the hydrophilic treatment that only increases the wettability of the solution that becomes the precursor 12A for the photoelectric conversion layer 12. By performing such a vacuum plasma treatment, the hydrophilic property of the surface 11a of the hole transport layer 11 can be increased for a shorter treatment period of time.

Note that such a hydrophilic treatment may be an atmospheric plasma treatment that is a plasma treatment, or a UV ozone treatment. When the hydrophilic treatment is performed by the UV ozone treatment, the hydrophilic treatment simply needs to be performed longer as compared to the normal hydrophilic treatment (such as Comparative Example 1 described later).

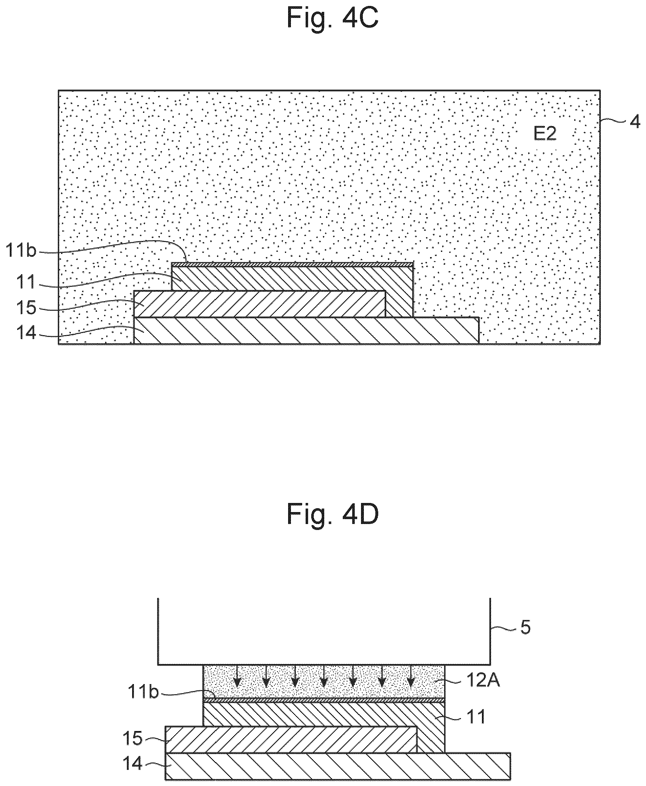

Next, in step S3, moisture 22 is absorbed in the surface 11a of the hole transport layer 11 that was subjected to the hydrophilic treatment. Specifically, as shown in FIG. 4C, with a space E2 inside a chamber 4 humidified so as to have a predetermined humidity, the first substrate 14 where the hole transport layer 11 and the like after being subjected to the hydrophilic treatment are formed is housed in the chamber 4. With such a state, when the surface 11a that was subjected to the hydrophilic treatment is exposed in the humidified atmosphere, the moisture suspending in the space E2 is absorbed in the surface 11a of the hole transport layer 11. That is, in this step S3, the moisture present around the surface 11a of the hole transport layer 11 is absorbed in the surface 11a so that micro moisture is uniformly absorbed in the surface 11a of the hole transport layer 11. The moisture absorbed in the surface 11a of the hole transport layer 11 is in an amount that is visually unrecognizable as droplets, unlike condensate. Note that in the following description, the surface 11a with the moisture 22 absorbed therein is referred to as a surface 11b.

In step S3, the amount of moisture absorbed in the surface 11a of the hole transport layer 11 can be controlled by controlling the humidity within the space E2 inside the chamber 4 and the time during which the hole transport layer 11 is being input in the space E2. However, as long as the amount of moisture absorbed in the surface 11a of the hole transport layer 11 can be controlled, the moisture may be absorbed in the surface 11a of the hole transport layer 11, without housing the first substrate 14 with the hole transport layer 11 formed thereon in the chamber 4.

Next, in step S4, the precursor 12A for the photoelectric conversion layer 12 is applied to the surface 11b of the hole transport layer 11 with the moisture 22 absorbed therein. Specifically, as shown in FIG. 4D, the precursor 12A in an ink form for the photoelectric conversion layer 12 is applied to the surface 11b using a die coating method, for example. More specifically, the precursor 12A is supplied into a slit die 5, and the precursor 12A is discharged from the inside of the slit die 5 while relatively moving the slit die 5 or the hole transport layer 11 in a direction orthogonal to the sheet surface of FIG. 4D so as to uniformly apply the precursor 12A to the surface 11b.

Note that the manufacturing method for the solar cell module 1 according to the present embodiment uses the die coating method to apply the precursor 12A, but the application method is not limited as long as the precursor 12A can be applied in a uniform film thickness. For example, an inkjet method, a spray method, a spin coating method, or the like may be used to apply the precursor 12A. Examples of the precursor 12A may include ink (solution) in which lead iodide or methylammonium iodide is dissolved in a solvent such as DMF or DMSO. During the process of heating and drying the coating of the applied precursor 12A and thereby evaporating the solvent, constituent ions are crystalized into a perovskite crystal. Note that before proceeding to step S5, a solvent (poor solvent) in which a perovskite compound is difficult to dissolve may be dropped into the applied precursor 12A (solution) to thus promote the generation of a seed crystal of the perovskite compound. This can obtain a perovskite layer (photoelectric conversion layer 12) having excellent membranous properties and can thus increase the conversion efficiency of the solar cell module 1.

Next, in step S5, the applied precursor 12A is heated to form the photoelectric conversion layer 12 from the precursor 12A. Concurrently, the moisture 22 absorbed in the surface 11a of the hole transport layer 11 is evaporated so that the plurality of vacancies 21 is formed at the interface 25 of the photoelectric conversion layer 12 contacting the hole transport layer 11.

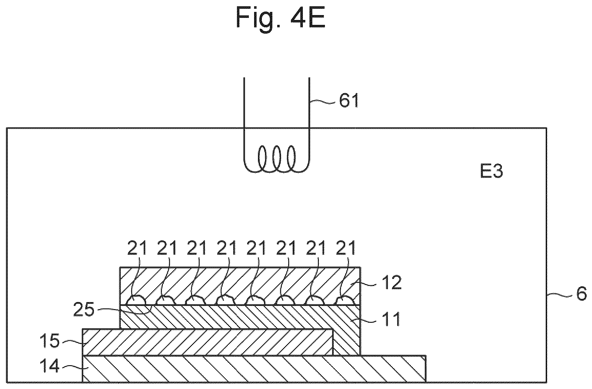

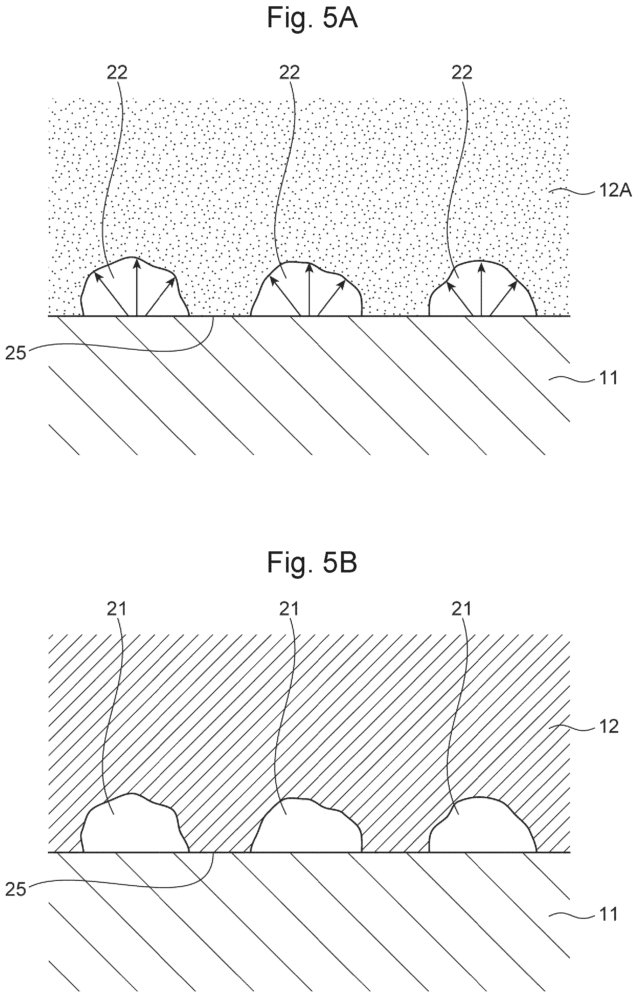

Specifically, as shown in FIG. 4E, the first substrate 14 in which the precursor 12A is applied to the surface 11b of the hole transport layer 11 is housed in a chamber 6 provided with a heater 61 in its upper portion. The temperature of a space E3 inside the chamber 6 is increased by the operation of the heater 61, and the first substrate 14 is input to the chamber 6 so that the precursor 12A is heated. As a result, as shown in FIG. 5A, the moisture 22 absorbed in the surface 11b thermally expands and further, as shown in FIG. 5B, the constituent ions of the precursor 12A are crystalized into a perovskite crystal to form the photoelectric conversion layer 12.

Specifically, as shown in FIG. 5A, prior to crystallization of the constituent ions of the precursor 12A, the moisture 22 absorbed in the surface 11b of the hole transport layer 11 expands in volume due to heat to push away the precursor 12A contacting the surface 11b of the hole transport layer 11. With such a state, the crystallization of the constituent ions of the precursor 12A proceeds, and as shown in FIG. 5B, the plurality of vacancies 21 is formed at the interface 25 of the photoelectric conversion layer 12 contacting the hole transport layer 11. Note that in step S5, the first substrate 14 may be directly heated using a heater (heating plate) without using the chamber 6 shown in FIG. 4E.

Here, multiple vacancies 21 are formed so as to be recessed toward the photoelectric conversion layer 12 from the interface 25. The aforementioned vacancy forming ratio of the vacancies 21 can be adjusted as follows. Specifically, the amount of the moisture 22 absorbed in the surface 11b of the hole transport layer 11 can be adjusted by changing either the irradiation intensity and time (i.e., integrated intensity) of the plasma P or the like in step S2 or the humidity under an exposure atmosphere and the exposure time in step S3. For example, when the integrated intensity of the plasma P in step S2 is increased, the amount of the functional group contributing to the hydrophilic property increases to thus increase the absorption amount of the moisture 22. Likewise, when the humidity under the exposure atmosphere or the exposure time in step S3 is increased, the absorption amount of the moisture 22 increases. In this manner, the number and the size of the vacancies 21 to be formed can be changed in accordance with the absorption amount of the moisture 22 absorbed in the surface 11b of the hole transport layer 11. As a result, the vacancy forming ratio of the vacancies 21 can be adjusted.

Next, in step S6, the electron transport layer 13 is formed from a precursor (not shown) for an electron transport layer using the same method (the method described in step S1) as the method of forming the hole transport layer 11. Next, in step S7, the second electrode 16 is formed so as to contact the electron transport layer 13. Finally, in step S8, the hole transport layer 11, the photoelectric conversion layer 12, the electron transport layer 13, and the like are sealed with the adhesive sealing material 17. Then, the second substrate 18 is bonded to the adhesive sealing material 17 to complete the solar cell module 1.

### [Examples]

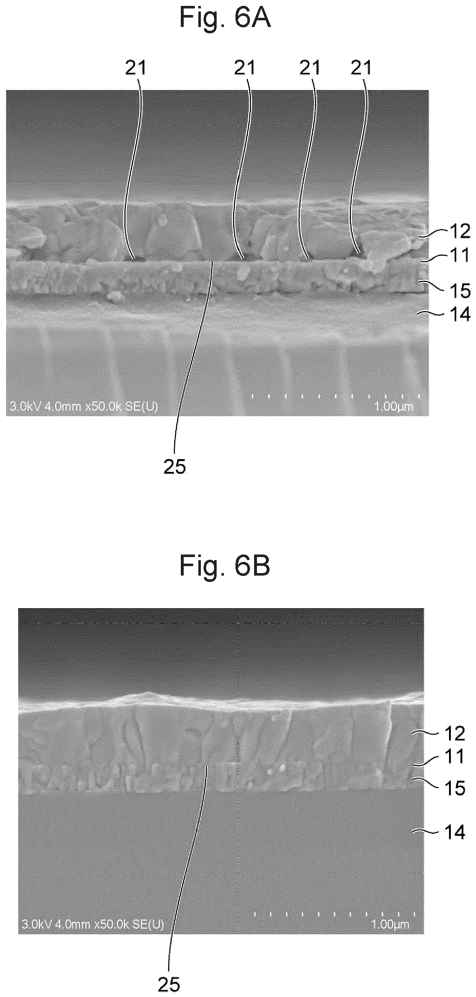

Hereinafter, with reference to the drawings of FIG. 6 to FIG. 8, examples embodying the present disclosure, together with Comparative Example, will be described.

### [Example 1-1]

Using a manufacturing method shown below, a test sample of the solar cell module 1 (hereinafter, referred to as a "test sample") according to Example 1-1 was manufactured. The first electrode 15 (hereinafter, referred to as an "ITO 15") composed of ITO was deposited on the first substrate 14 (hereinafter, referred to as a "glass substrate 14") composed of no alkali glass using a sputtering method. At this time, the transmittance of a visible region was equal to or higher than 85% and the sheet resistance was equal to or lower than 10 Ω/. The glass substrate 14 with the ITO 15 processed into a given pattern through lithography was subjected to ultrasonic cleaning, as wet cleaning, in 1-propanol and then in ethanol, and was then treated at 300 mW for 10 minutes, as dry cleaning, using a UV ozone generator (ASM4010Z, ASUMI GIKEN Co., Ltd.).

Next, the hole transport layer 11 was formed on a surface of the glass substrate 14 with the ITO 15. Specifically, HTL ink (a precursor for the hole transport layer 11) in which a 5.0 mg/ml of PTAA was dissolved in 1-Chrolobenzen was dropped onto the ITO 15 and was then deposited at 2000 rpm for 40 seconds by spin coating. Thereafter, the glass substrate 14 was placed on a hot plate to heat and dry the deposited precursor under the heating condition of 100°C for 10 minutes so that the hole transport layer 11 was formed.

The surface 11a of the obtained hole transport layer 11 was subjected to hydrophilic treatment. Specifically, using a vacuum plasma system YHS-R (manufactured by SAKIGAKE-Semiconductor Co., Ltd.), the surface 11a of the hole transport layer 11 was irradiated with the plasma P under the conditions of an irradiation range of 100 mm in diameter, an irradiation intensity of 40W, and an irradiation time for 1 second. That is, under the conditions, in the vacuum plasma treatment, the integrated intensity indicating the irradiation intensity per unit irradiation area of the plasma P is 509 mJ/cm². Note that the irradiation intensity of 40W is higher than the irradiation intensity in the general hydrophilic treatment of the surface 11a of the hole transport layer 11 and this integrated intensity is higher than the integrated intensity in the general hydrophilic treatment.

Next, under the conditions of 25°C and 65% humidity, the glass substrate 14 including the hole transport layer 11 that was subjected to the hydrophilic treatment was placed for a given period of time (specifically, 1 minute) to cause the surface 11a of the hole transport layer 11 that was subjected to the hydrophilic treatment to absorb the moisture so that the moisture was absorbed in the surface 11a of the hole transport layer 11.

Next, on the surface 11b of the hole transport layer 11, the precursor 12A for a perovskite layer was applied to be formed. The precursor 12A was in an ink form. A solvent of a mixture of DMF (N,N-dimethylformamide) and DMSO (Dimethyl sulfoxide) at a ratio of 4:1 was used, and lead iodide, cesium iodide, formamidine hydroiodide, and methylamine hydroiodide were added as dissolved substances by 1.2M, and heat treatment at 150°C for 10 minutes was performed for dissolution. The prepared precursor 12A was dropped onto the surface 11b of the hole transport layer 11 with the moisture absorbed therein and was deposited at 1000 rpm for 10 seconds, and further at 6000 rpm for 20 seconds by spin coating. At this time, in order to promote generation of perovskite crystal nuclei, 200 µl of 1-Chlorobezene was dropped, as a poor solvent treatment, onto the surface 11b of the hole transport layer 11 during rotation, 5 seconds before completion of the deposition by spin coating. After the rotation was completed, the glass substrate 14 where a film of the precursor 12A was formed was placed on a hot plate and the deposited precursor 12A was heated and dried under the heating condition of 100°C for 60 minutes so that the photoelectric conversion layer 12 (perovskite layer) was formed.

Next, the electron transport layer 13 was formed on a surface of the perovskite layer. Here, as the electron transport layer 13, a stacked film of a PCBM ([6,6]-Phenyl-C61-Butylic Acid Methyl Ester) layer and a BCP (Bathocuproine) layer was deposited. Specifically, ink in which PCBM was dissolved in 1-Chlorobenzen by 12.0 g/l was dropped onto the surface of the photoelectric conversion layer 12 and was then deposited at 8000 rpm for 30 seconds by spin coating, and heating and drying at 100°C for 10 minutes on a hot plate were performed. Next, ink in which BCP was dissolved in super dehydrated 2-Propanol by 1.0 g/l was dropped onto a surface of the PCBM layer, and was deposited at 4000 rpm for 30 seconds by spin coating and was dried.

To remove unnecessary portions of the power generation portion 10 composed of the hole transport layer 11, the photoelectric conversion layer 12, and the electron transport layer 13 that were deposited on the surface of the glass substrate 14, trimming was performed with a laser having a wavelength of 355 nm, an output of 1.5 W, a sweep rate of 1500 mm/sec, and a frequency of 80 kHz, using a UV laser marker MD-U1020C (manufactured by Keyence Corporation).

Next, as the second electrode 16 that is an electrode opposing the ITO15, a silver electrode having a thickness of 100 nm was formed. Specifically, through thermal vapor deposition under a high vacuum of 1.0 × 10⁻³ Pa or lower, silver was vapor-deposited on a surface of the electron transport layer 13 so that the second electrode 16 composed of silver was formed. Finally, a barrier film PT/25GT3 (manufactured by Oike Advanced Film Co., Ltd.) having a low water vapor transmittance as the second substrate 18 and an adhesive sheet material TESA61562 (manufactured by tesa tape K.K.) as the adhesive sealing material 17 were prepared. Here, in order to prevent deterioration of the power generation portion 10 due to moisture or oxygen in the atmosphere, the adhesive sealing material 17, together with the second substrate 18, was thermally laminated on the glass substrate 14 where the power generation portion 10 was formed so as to entirely seal the power generation portion 10 and the like.

### [Example 1-2]

The test sample was prepared in the same manner as in Example 1-1. Example 1-2 differs from Example 1-1 in that with an integrated intensity of 1018 mJ/cm² obtained by irradiating the plasma P under the condition of an irradiation time of 2 seconds, the hydrophilic treatment was performed by the vacuum plasma treatment.

### [Example 1-3]

The test sample was prepared in the same manner as in Example 1-1. Example 1-3 differs from Example 1-1 in that with an integrated intensity of 1528 mJ/cm² obtained by irradiating the plasma P under the condition of an irradiation time of 3 seconds, the hydrophilic treatment was performed by the vacuum plasma treatment.

### [Comparative Example 1]

The test sample was prepared in the same manner as in Example 1-1. Comparative Example 1 is a comparative example for evaluating an optimum hydrophilic treatment method. Comparative Example 1 differs from Example 1-1 in that the UV ozone treatment was performed as the hydrophilic treatment method and moisture was not absorbed. Specifically, the UV ozone treatment was performed under the conditions of an irradiation range of 120 mm in diameter, an irradiation intensity of 300 mW, and an irradiation time for 3 minutes. That is, under the conditions, in the UV ozone treatment, with an integrated intensity indicating the irradiation intensity per unit irradiation area of 378 mJ/cm², the hydrophilic treatment was performed.

### <Observation results of cross section>

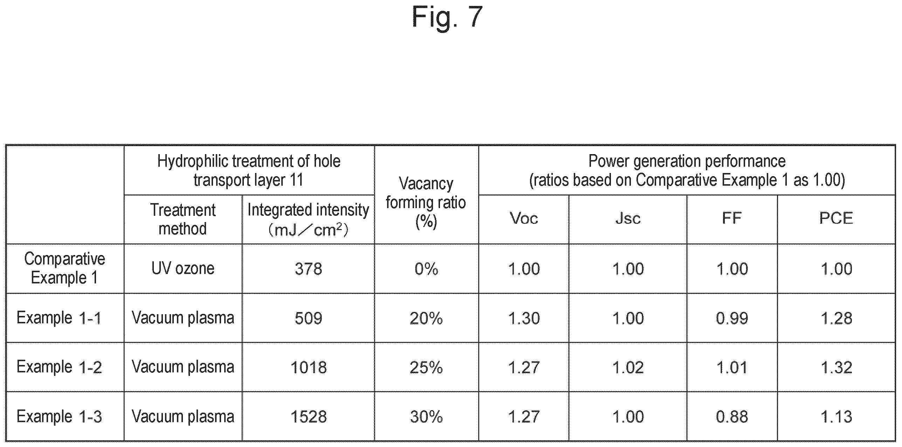

Cross sections of the test samples according to Examples 1-1 to 1-3 and Comparative Example 1 were observed using an SEM (scanning electron microscope). FIG. 6A shows a photographed structure of the cross section of the test sample according to Example 1-1 and FIG. 6B shows a photographed structure of the cross section of the test sample according to Comparative Example 1. As shown in FIG. 6A, in the test sample of Example 1-1, the plurality of vacancies 21 is formed at the interface 25 of the photoelectric conversion layer 12 contacting the hole transport layer 11. Meanwhile, as shown in FIG. 6B, in the test sample of Comparative Example 1, no vacancies 21 were formed at the interface 25 of the photoelectric conversion layer 12 contacting the hole transport layer 11. Note that also in the test samples according to Examples 1-2 and 1-3, the vacancies 21 were formed at the interface 25 of the photoelectric conversion layer 12 contacting the hole transport layer 11. Further, the vacancy forming ratio of the vacancies 21 was measured from the cross sections of the test samples of Examples 1-1 to 1-3. The results are shown in FIG. 7. As shown in FIG. 7, it was found that the vacancy forming ratio increases in proportion to the increase in the integrated intensity in the vacuum plasma treatment.

### <Consideration>

It was found from the foregoing that for forming the vacancies 21 at the interface 25, it is appropriate to employ the vacuum plasma treatment as the hydrophilic treatment and then to perform moisture absorption in the surface 11a of the hole transport layer 11, as in Examples 1-1 to 1-3. Note that the UV ozone treatment according to Comparative Example 1 is only directed to improving the wettability of the surface 11a of the hole transport layer 11 to the precursor 12A for the perovskite layer. Therefore, it is recognized that without the hydrophilic treatment such as the UV ozone treatment being performed, it is difficult to apply the precursor 12A for the perovskite layer in a uniform film thickness, thereby making it difficult to form the perovskite layer. However, when the irradiation in the hydrophilic treatment is performed several to several ten times longer than the irradiation time for Comparative Example 1 so as to allow moisture suspending in the atmosphere to be absorbed in the surface 11a of the hole transport layer 11 as well as to improve the wettability of the surface 11a of the hole transport layer 11, it seems possible to form the vacancies by performing the UV ozone treatment as the hydrophilic treatment.

### <Evaluation of power generation performance>

Next, the test samples according to Example 1-1 to Example 1-3 and Comparative Example 1 were each covered with a shadow mask having an opening smaller than an effective power generation area. Next, using a solar simulator XI-05A1V2-L (manufactured by SERIC Ltd.), a reciprocating sweep was performed under simulated sunlight 1SUN (1000 W/m²), between -0.2 V and +1.2 V using a source meter Keithley 2401 (manufactured by Keithley Instruments, Inc.) to obtain a current value at each voltage so that the power generation efficiency was measured. The results are shown in FIG. 7.

Note that regarding the parameters of power generation performance shown in FIG. 7, V_{OC}, J_{SC}, FF, and PCE represent an open-circuit voltage, a short-circuit current density, a fill factor, and a quantum efficiency, respectively. Note that the values of Examples 1-1 to 1-3 shown in FIG. 7 were obtained through division by the the values of Comparative Example 1 (standardized values). Thus, each of these values is the ratio based on each value of Comparative Example 1 as 1.00. It is also recognized from FIG. 7 that for forming the vacancies 21 at the interface 25, adopting the vacuum plasma treatment as the hydrophilic treatment is advantageous, as described above. Further, it is recognized that by adjusting the irradiation time and the irradiation intensity of the plasma P to allow the integrated intensity to be within a range from 509 mJ/cm² to 1528 mJ/cm², the vacancies 21 can be formed at the interface 25 with the vacancy forming ratio within a range from 20% to 30%. Furthermore, it is recognized that when the vacancy forming ratio is within the range from 20% to 30%, V_{OC} is improved as compared to Comparative Example 1 (Comparative Example having a 0% vacancy forming ratio). In addition, it is found that PCE, which can be represented by a product of V_{OC}, J_{SC}, and FF, also improves as V_{OC} improves. Thus, it is also recognized that even when V_{OC} improves, the decrease in J_{SC} and FF is insignificant and that PCE improves as V_{OC} improves. Note that since variations among the values of the power generation performance according to Examples 1-1 to 1-3 are insignificant, any value of the vacancy forming ratio within the range from 20% to 30% may contribute to the improvement of V_{OC}.

The test samples according to Example 2-1 to Example 2-6 and Comparative Example 2 were manufactured as below. In these examples, variations in the power generation performance of the solar cell modules manufactured under the same conditions were examined and in Example 2-3 to Example 2-6, the power generation performance of the solar cell modules by further performing the hydrophilic treatment was examined.

### [Example 2-1 to Example 2-3]

Four test samples according to Example 2-1 were prepared in the same manner as in Example 1-1. Four test samples according to Example 2-2 were prepared in the same manner as in Example 1-2. Four test samples according to Example 2-3 were prepared in the same manner as in Example 1-3. Note that the average vacancy forming ratio of these test samples was 20%, 25%, and 30%, respectively.

### [Example 2-4]

Four test samples were prepared in the same manner as in Example 2-1. Example 2-4 differs from Example 2-1 in that with an integrated intensity of 2036 mJ/cm² obtained by irradiating the plasma P under the condition of an irradiation time of 4 seconds, the hydrophilic treatment was performed by the vacuum plasma treatment. Note that the average vacancy forming ratio of the test samples was 35%.

### [Example 2-5]

Four test samples were prepared in the same manner as in Example 2-1. Example 2-5 differs from Example 2-1 in that with an integrated intensity of 2545 mJ/cm² obtained by irradiating the plasma P under the condition of an irradiation time of 5 seconds, the hydrophilic treatment was performed by the vacuum plasma treatment. Note that the average vacancy forming ratio of the test samples was 40%.

### [Example 2-6]

Four test samples were prepared in the same manner as in Example 2-1. Example 2-6 differs from Example 2-1 in that with an integrated intensity of 3054 mJ/cm² obtained by irradiating the plasma P under the condition of an irradiation time of 6 seconds, the hydrophilic treatment was performed by the vacuum plasma treatment. Note that the average vacancy forming ratio of the test samples was 45%.

### [Comparative Example 2]

Four test samples were prepared in the same manner as in Comparative Example 1. Note that Comparative Example 2 differs from Examples in that the UV ozone treatment was performed and moisture was not absorbed as described above. Note that vacancies were not formed on the photoelectric conversion layers of the test samples, with the same results as shown in FIG. 6B.

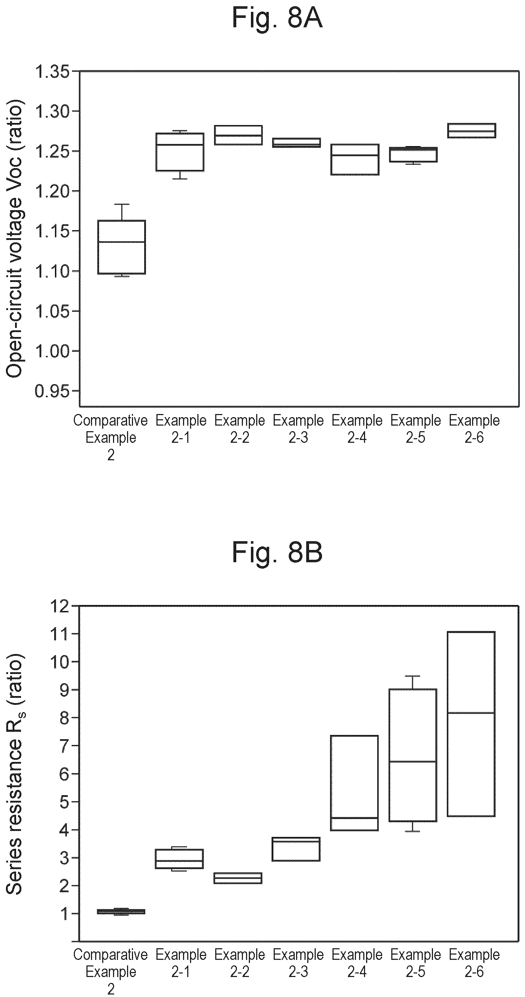

To evaluate the aforementioned power generation performance of the four test samples of each of Example 2-1 to Example 2-6 and Comparative Example 2, the open-circuit voltage and the series resistance were measured, the results of which are shown in FIG. 8A and FIG. 8B, respectively. Note that the graphs of FIG. 8A and FIG. 8B are box plots of Example 2-1 to Example 2-6 and Comparative Example 2. Note that the values of Example 2-1 to Example 2-6 shown in FIG. 8A are ratios (standardized values) obtained through division by the measured value of the open-circuit voltage of Comparative Example 1. Note that the values of the series resistance of Example 2-1 to Example 2-6 shown in FIG. 8B are ratios (standardized values) obtained through division by the measured value of the series resistance of Comparative Example 2.

As shown in FIG. 8A, the open-circuit voltage V_{OC} of each test sample of Example 2-1 to Example 2-6 was greater than that of Comparative Example 2. This is assumed to be because in Example 2-1 to Example 2-6, the vacancies 21 were formed at the interface 25 of the photoelectric conversion layer 12 contacting the hole transport layer 11. Meanwhile, as shown in FIG. 8B, the median in the box plot of the series resistance Rₛ of each test sample of Example 2-4 to Example 2-6 was greater than that of Example 2-1 to Example 2-3. However, the first quartile value and the minimum value in the box plot of each of Example 2-4 to Example 2-6 were around the same as the maximum value of the series resistance Rₛ of each of Example 2-1 to Example 2-3.

From the foregoing, it was found that with the integrated intensity, which is the condition of plasma irradiation, exceeding 1528 mJ/cm², that is, the vacancy forming ratio exceeding 30%, as in the test samples of Example 2-4 to Example 2-6, the open-circuit voltage V_{OC} of the solar cell module can still stably be improved. However, even in such a case, as the integrated intensity and the vacancy forming ratio increase, the series resistance Rₛ of the solar cell module tends to vary in the increasing direction. Thus, as the manufacturing conditions, the integrated intensity as the condition of plasma irradiation may be equal to or greater than 509 mJ/cm² and may be equal to or smaller than 1528 mJ/cm². The vacancy forming ratio may be equal to or greater than 20% and equal to or smaller than 30%.

The embodiment of the present disclosure has been described in detail, but the present disclosure is not limited to the aforementioned embodiment, and various design changes can be made within the scope of the spirit of the present disclosure described in the claims.

In the present embodiment, the perovskite solar cell module in an inverted structure has been described. However, for example, the perovskite solar cell module may be in a sequential structure with the power generation portion 10 in which the electron transport layer 13, the photoelectric conversion layer 12, and the hole transport layer 11 are sequentially arranged from below in FIG. 1. In this case, the sequence of the manufacturing process for the solar cell module shown in the embodiment also differs. Specifically, the second substrate 18 where the second electrode 16 and the hole transport layer 11 are formed is prepared and the same treatment as that of the present embodiment is performed on the hole transport layer 11 and the photoelectric conversion layer 12, and then, the translucent first electrode 15 may be formed. Finally, the translucent first substrate 14 is provided via the adhesive sealing material 17, so that the perovskite solar cell module in a sequential structure can be obtained.

### DESCRIPTION OF SYMBOLS

- 1: Solar cell module
- 11: Hole transport layer
- 12: Photoelectric conversion layer
- 12A: Precursor
- 13: Electron transport layer
- 14: First substrate (glass substrate)
- 21: Vacancy
- 25: Interface

## Claims

1. A manufacturing method for a solar cell module (1) in which a hole transport layer (11), a photoelectric conversion layer (12), and an electron transport layer (13) are stacked, the manufacturing method comprising:
preparing a substrate where the hole transport layer (11) is formed;
performing a hydrophilic treatment on a surface of the hole transport layer (11) formed on the substrate prepared;
causing the surface of the hole transport layer (11) on which the hydrophilic treatment is performed to absorb moisture;
applying a precursor (12A) for the photoelectric conversion layer (12) to the surface of the hole transport layer (11) in which the moisture is absorbed;
heating the precursor (12A) applied so as to form the photoelectric conversion layer (12) from the precursor (12A) and vaporizing the moisture absorbed in the surface of the hole transport layer (11), thereby forming a plurality of vacancies at an interface (25) of the photoelectric conversion layer (12) contacting the hole transport layer (11); and
forming the electron transport layer (13) on a surface of the photoelectric conversion layer (12).

2. The manufacturing method for a solar cell module (1) according to claim 1, wherein in the performing the hydrophilic treatment on the surface of the hole transport layer (11), the hydrophilic treatment is performed by a plasma treatment or a UV ozone treatment.

3. The manufacturing method for a solar cell module (1) according to claim 2, wherein
the plasma treatment is a vacuum plasma treatment, and
in the vacuum plasma treatment, plasma is irradiated to the surface of the hole transport layer (11), with an integrated intensity indicating an irradiation intensity per unit irradiation area of the plasma being equal to or greater than 509 mJ/cm².

4. The manufacturing method for a solar cell module (1) according to claim 3, wherein in the vacuum plasma treatment, the plasma is irradiated to the surface of the hole transport layer (11), with the integrated intensity being equal to or smaller than 1528 mJ/cm².

5. A solar cell module (1) in which a hole transport layer (11), a photoelectric conversion layer (12), and an electron transport layer (13) are stacked,
wherein a plurality of vacancies is formed at an interface (25) of the photoelectric conversion layer (12) contacting the hole transport layer (11).

6. The solar cell module (1) according to claim 5, wherein on a cut surface obtained by cutting, along a thickness direction, the hole transport layer (11) and the photoelectric conversion layer (12), a ratio of a total length of a surface of the hole transport layer (11), the surface adjacent to the plurality of vacancies, relative to an entire length of the hole transport layer (11) facing the photoelectric conversion layer (12) is equal to or greater than 20%.

7. The solar cell module (1) according to claim 6, wherein, the ratio of the total length of the surface of the hole transport layer (11), the surface adjacent to the plurality of vacancies, relative to the entire length of the hole transport layer (11) facing the photoelectric conversion layer (12) is equal to or smaller than 30%.
